# FASCICULE DE BREVET EUROPEEN

(11) **EP 0 564 467 B1**
(45) Date de publication et mention de la délivrance du brevet: **12.03.1997**
(21) Numéro de dépôt: 91919510.7
(22) Date de dépôt: 25.10.1991
(51) Int. Cl.: H01L 23/60, H01L 23/62, G02F 1/136

(54) **CIRCUIT DE PROTECTION D'UN INSTRUMENT A SEMI-CONDUCTEURS CONTRE LA TENSION PRODUITE PAR LES DECHARGES D'ELECTRICITE STATIQUE**
SCHUTZSCHALTUNG FüR EIN HALBLEITERAPPARAT GEGEN DIE SPANNUNG ELECTROSTATISCHER ENTLADUNGEN
CIRCUIT FOR PROTECTING A SEMICONDUCTOR DEVICE FROM VOLTAGE PRODUCED BY DISCHARGES OF STATIC ELECTRICITY

(43) Date de publication de la demande: 13.10.1993
(73) Titulaire: THOMSON S.A., 92800 Puteaux (FR)
(72) Inventeur: DRESNER, Joseph, F-92045 Paris-La Défense Cédex 67 (FR)
(74) Mandataire: Ruellan-Lemonnier, Brigitte
(86) Numéro de dépôt international: FR9100846
(87) Numéro de publication internationale: WO9308602

(56) Documents cités:
- EP-A- 0 075 892
- EP-A- 0 115 143
- EP-A- 0 261 939
- EP-A- 0 369 450
- EP-A- 0 369 828
- EP-A- 0 416 903
- FR-A- 2 085 918
- US-A- 4 714 949
- PATENT ABSTRACTS OF JAPAN vol. 8, no. 95 (E-242)(1532) 2 Mai 1984 & JP,A,59 013 354
- PATENT ABSTRACTS OF JAPAN vol. 15, no. 5 (P-1149)8 Janvier 1991 & JP,A,2 254 421

## Description

La présente invention concerne de façon générale un circuit de protection d'un instrument à semi-conducteurs contre les décharges d'électricité statique et, plus particulièrement, un circuit de ce type dans lequel les composants de protection sont des dispositifs à semi-conducteurs.

Les dispositifs à semi-conducteurs, tels que les écrans à cristaux liquides à matrice active, peuvent être détériorés par les décharges d'électricité statique élevées, telles que les décharges produites par le corps humain (HBD). Les décharges produites par le corps humain sont fréquemment de l'orale de 2.000 à 2.500 volts et peuvent même atteindre 10.000 volts. Les tensions de ces niveaux sont capables de détruire les dispositifs à semi-conducteurs à l'intérieur des instruments qui ne comprennent pas un moyen quelconque de protection contre ces décharges. Une protection efficace contre les décharges de tension électrostatique doit être en mesure de protéger l'instrument à semi-conducteurs contre les décharges de basse et de haute tension, et le temps de commutation des dispositifs de protection doit être suffisamment court pour garantir que les décharges sont shuntées vers la terre avant de détériorer l'instrument protégé. Les dispositifs de commutation doivent aussi être capables de protéger l'instrument à semi-conducteurs contre les décharges d'électricité statique multiples auxquelles l'instrument peut être soumis durant sa durée de vie utile

Pour répondre à ces besoins, on a déjà proposé dans le brevet EP-A-0 369 450 un circuit de protection pour dispositif électro-optique. La présente invention propose un circuit de ce type particulier.

Un circuit de protection pour protéger un instrument à semi-conducteurs contre les décharges de tension produites par l'électricité statique comprend une pluralité de dispositifs fusibles à semi-conducteurs montés en parallèle avec la capacitance d'entrée de l'instrument à semi-conducteurs, les dispositifs fusibles protègent cet instrument contre les décharges d'électricité statique au-dessus d'une tension minimum par claquage d'un de ces dispositifs fusibles. Un dispositif de commutation à semi-conducteurs est monté en parallèle avec les fusibles pour shunter les courants produits par les décharges de tension au-dessous d'une tension minimum.

La FIGURE 1 représente un mode de réalisation préférentiel d'un circuit de protection contre les décharges de tension électrostatiques.

La FIGURE 2 est une coupe transversale d'un mode de réalisation préférentiel de l'un des dispositifs de protection du mode de réalisation préférentiel.

La FIGURE 3 est une représentation simplifiée d'une pluralité des dispositifs de protection du mode de réalisation préférentiel disposés en une seule bande à semi-conducteurs.

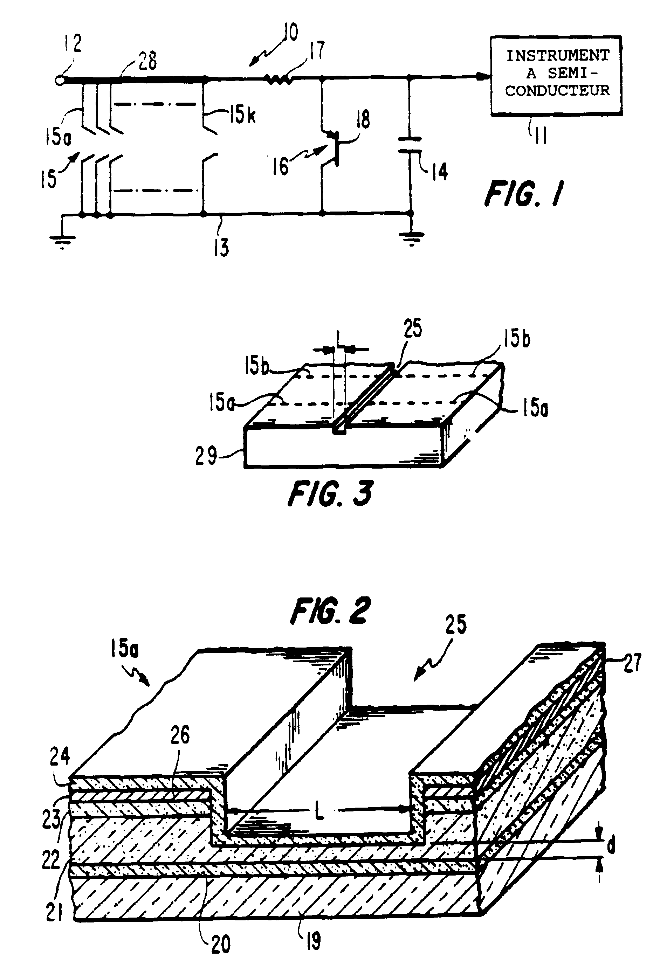

Sur la FIGURE 1, un circuit de protection 10 protège un instrument à semi-conducteurs 11 contre des décharges de tension électrostatiques, par exemple les décharges produites par le corps humain (HBD), qui sont provoquées par l'électricité statique qui se forme sur l'utilisateur de l'instrument à semi-conducteurs 11. Les décharges produites par le corps humain peuvent atteindre 10.000 volts, bien que la plupart ne dépassent pas 2.500 volts. L'instrument à semi-conducteurs 11 peut être un dispositif à affichage à cristaux liquides ayant un circuit de commande à semi-conducteurs qui sert à mettre les divers pixels de l'écran sous et hors tension, selon l'affichage désiré. Le circuit de protection 10 comprend une ligne d'entrée 12 qui amène le signal produisant l'affichage à l'instrument à semi-conducteurs 11. Le circuit 10 comprend aussi une ligne de terre 13. La capacitance d'entrée de l'instrument à semi-conducteurs 11 est représentée par une capacité 14 montée entre la ligne d'entrée 12 et la ligne de terre 13. Une pluralité de dispositifs fusibles en substance identiques 15a à 15k est montée en parallèle avec la capacitance d'entrée 14 de l'instrument à semi-conducteurs 11. De plus, un dispositif de commutation à semi-conducteurs 16, qui est de préférence un transistor en couches minces (TFT), fonctionnant avec grille flottante, est également monté en parallèle avec la capacitance d'entrée 14. Une résistance 17 est montée sur la ligne d'entrée 12 et, en combinaison avec la capacitance d'entrée 14 de l'instrument à semi-conducteurs 11, a une valeur sélectionnée de manière que la constante de temps RC du réseau résistance-capacitance soit, de préférence, inférieure au temps de mise en marche du TFT 16 et supérieure au temps d'amorçage des dispositifs fusibles 15a à 15k. En pratique, RC est aussi élevée que possible, en conformité avec la fréquence maximum du signal amené au terminal d'entrée 12. Si l'instrument à semi-conducteurs 11 est un dispositif d'affichage à cristaux liquides, chaque pixel de ce dispositif constitue une capacité qui contribue à la capacitance d'entrée 14 et, par conséquent, la valeur de la résistance 17 est influencée par le nombre de pixels du dispositif d'affichage.

Les dispositifs fusibles 15a à 15k sont des dispositifs à semi-conducteurs et servent à protéger l'instrument à semi-conducteurs 11 contre les décharges de tension électrostatiques au-dessus d'une tension prédéterminée, par exemple 300 volts. Une pluralité de dispositifs fusibles 15a à 15k est utilisée, parce que les décharges produites par le corps humain au-dessus d'un niveau maximum font claquer l'un des dispositifs. Dans ce cas, le claquage de l'un des fusibles protège l'instrument à semi-conducteurs 11 de la détérioration. Les autres dispositifs fusibles du circuit continuent à assurer la protection de l'instrument à semi-conducteurs 11 contre d'autres détériorations au-dessus de leur niveau de claquage. Le dispositif de commutation 16 est un transistor en couches minces possédant une grille 18 qui flotte. Le TFT 16 protège l'instrument à semi-conducteurs 11 contre les décharges de tension électrostatiques qui se situent au-dessous de la tension minimum à laquelle les fusibles 15a à 15k protègent l'instrument 11. Il faut un seul TFT parce que les tensions électrostatiques de valeur suffisante pour détruire le TFT sont shuntées par les dispositifs fusibles 15a à 15k. Ainsi, l'instrument 11 est protégé à vie contre les décharges de tension électrostatiques à tous les niveaux capables de détériorer ses circuits internes.

Comme le montre la FIGURE 2, les dispositifs fusibles 15a à 15k sont des dispositifs à semi-conducteurs en silicium amorphe (a-Si). Ces dispositifs fusibles 15a à 15k sont fabriqués sur un substrat en verre 19. Une couche 20 de nitrure de silicium Si₃N₄ recouvre le substrat en verre. Une couche 21 de silicium amorphe non dopé recouvre la couche de Si₃N₄ 20. Une couche 22 de silicium amorphe dopé est ensuite placée au-dessus de la couche non dopée 21. La couche 21 est de préférence un matériau dopé n, bien qu'il soit possible d'utiliser aussi des matériaux de type p. Une couche d'électrode 23, qui est de préférence en molybdène, est déposée sur la couche de silicium amorphe dopé 22. Un canal 25 est gravé ou formé de toute autre façon dans le dispositif 15a à une profondeur telle que le fond de ce canal soit à une distance d de la couche de Si₃N₄ 20. Enfin, une couche supérieure 24 de Si₃N₄ est déposée à travers toute la surface supérieure du fusible 15a y compris le canal 25. La dimension L dans le sens transversal du canal 25, ainsi que la distance d entre la couche de Si₃N₄ 24 et l'autre couche de Si₃N₄ 20 sont essentielles pour déterminer la tension de claquage des dispositifs fusibles 15a à 15k. De plus, les épaisseurs des couches de Si₃N₄ 20 et 24 sont également importantes. Une dimension W, qui est la largeur totale parallèle au canal 25, n'est pas représentée, parce que les FIGURES 2 et 3 sont séparées. Cependant, W est fonction de l'intensité du courant sur le terminal 12 et donc déterminée par la nature de l'instrument 11. Les dimensions importantes du dispositif sont donc les suivantes :

La couche de Si₃N₄ 20, 200 nm à 400 nm, de préférence 300 nm.

La couche de Si₃N₄ 24, 100 nm à 400 nm, de préférence 150 nm.
d = 30 nm à 200 nm, de préférence 100 nm.
L ≤ 4 µm
W = 100 µm à 4.000 µm

La couche d'électrode 23 est formée sur la couche de a-Si 22 sous forme de lignes parallèles, toutes interrompues par le canal 25. L'écart entre les lignes conductrices est supérieur à la largeur L du canal 25 pour éviter les décharges entre lignes adjacentes si une décharge électrostatique se produit. Les dispositifs fusibles 15a à 15k sont connectés dans le circuit 10 par connexion d'une portion 26, située sur un côté du canal 25, au bus 28 du circuit 10. Une autre portion 27 des lignes conductrices, qui se trouve de l'autre côté du canal 25, est connectée à la ligne de terre 13. Le bus 28 est constitué du même matériau que les conducteurs parallèles et les autres conducteurs du circuit 10. Cependant, ce bus 28 est plus large que les autres conducteurs du circuit. Cette largeur supplémentaire maintient la continuité du bus lorsque l'un des dispositifs fusibles 15 claque. Sinon, une décharge électrostatique importante ferait fondre le bus et le conducteur fusible à la jonction où ils sont connectés. La largeur du bus 28 est de préférence au moins égale à quatre fois la largeur W des conducteurs 15.

Si l'un des dispositifs fusibles 15a à 15k est soumis à une charge électrostatique qui est suffisamment élevée pour le faire claquer, la couche supérieure 24 de Si₃N₄ fait claquer la couche de silicium amorphe non dopé 21 au travers de l'électrode en molybdène 23 et de la couche supérieure 22, empêchant ainsi le métal provenant de l'électrode conductrice 23 de retomber dans la portion claquée et de court-circuiter de façon permanente le dispositif fusible. Ce court-circuitage, s'il se produisait, rendrait l'instrument à semi-conducteurs 11 non-opérationnel parce que la ligne d'entrée 12 serait court-circuitée à la terre. Par conséquent, le dispositif est particulièrement avantageux parce que le claquage permanent de l'un des dispositifs fusibles 15a à 15k ne rend pas la protection contre la haute tension inefficace avant que tous les fusibles soient claqués, événement qui est très peu probable durant la durée de vie de l'instrument 11. Le circuit de protection 10 n'est que rarement soumis à des décharges d'électricité statique d'importance suffisante pour faire claquer l'un des dispositifs fusibles et, de ce fait, ce circuit 10 assure généralement une protection permanente, contre la haute tension, de l'instrument à semi-conducteurs avec lequel il est associé.

La FIGURE 3 représente la disposition d'une pluralité de barres omnibus 15 en un seul élément à semi-conducteurs 29, dont seule une portion est représentée. Deux conducteurs 15a et 15b, représentés par transparence, sont interrompus par le canal 25. L'écart entre conducteurs 15a et 15b est supérieur à la largeur L du canal 25. Si le terminal d'entrée 12 est soumis à une charge électrostatique d'importance suffisante, l'un des fusibles 15a à 15k s'amorce à travers le canal 25 et claque, empêchant ainsi l'instrument 11 d'être détérioré par la décharge d'électricité statique.

Le transistor en couches minces 16 qui sert de dispositif de commutation à semi-conducteurs est conçu de manière identique aux dispositifs fusibles 15a à 15k, si ce n'est qu'une électrode grille (non représentée sur la FIGURE 2) est appliquée au fond du canal 25 avant l'application de la couche supérieure de Si₃N₄ 24. La formation du transistor en couches minces 16 ne nécessite donc pas,de phases additionnelles de traitement. Les dimensions importantes du TFT 16 sont les suivantes :
L ≥ 10 µm, de préférence 12 µm
W = 100 µm à 600 µm, de préférence 200 µm
d est identique pour le TFT 16 et les fusibles
   15a à 15k, pour éviter la nécessité de phases de traitement additionnelles.

## Revendications

1. Circuit de protection (10) pour protéger un instrument à semi-conducteurs (11) contre les décharges d'électricité statique comprenant :
une pluralité de dispositifs fusibles à semi-conducteurs (15a-15k) montés en parallèle avec la capacitance d'entrée (14) dudit instrument à semi-conducteurs (11), lesdits dispositifs fusibles (15a-15k) protégeant ledit instrument (11) par claquage d'un de ces dispositifs fusibles lorsqu'ils sont soumis à une décharge d'électricité statique au-dessus d'une tension minimum ; et
un dispositif de commutation à semi-conducteurs (16) monté en parallèle avec lesdits dispositifs fusibles (15a-15k) pour shunter les courants produits par les décharges d'électricité statique au-dessous de ladite tension minimum.

2. Circuit de protection selon la revendication 1, caractérisé en ce qu'il comprend également une résistance (17) en combinaison avec ladite capacitance d'entrée (14), ladite résistance (17) ayant une valeur telle que la constante de temps résistance-capacité de ladite résistance (17) et de ladite capacitance d'entrée (14) est plus élevée que le temps de commutation desdits dispositifs fusibles (15a-15k) et inférieure à celui dudit dispositif de commutation (16).

3. Circuit de protection selon la revendication 2, caractérisé en ce que lesdits dispositifs fusibles (15a-15k) sont des dispositifs en silicium amorphe.

4. Circuit de protection selon la revendication 3, caractérisé en ce que lesdits dispositif de commutation à semi-conducteurs (16) est un transistor en couches minces en silicium amorphe.

5. Circuit de protection selon la revendication 4, caractérisé en ce que ledit transistor en couches minces (16) possède une grille flottante (18).

6. Circuit de protection selon la revendication 5, caractérisé en ce que ledit instrument à semi-conducteurs (11) est un dispositif d'affichage à cristaux liquides.

7. Circuit de protection selon la revendication 3, caractérisé en ce que lesdits dispositifs fusibles (15a-15k) sont disposés sur une seule bande à semi-conducteurs (15).

8. Circuit de protection selon la revendication 7, caractérisé en ce que ledit dispositif de commutation à semi-conducteurs (16) est un transistor en couches minces en silicium amorphe.

9. Circuit de protection selon la revendication 8, caractérisé en ce que ledit instrument à semi-conducteurs (11) est un dispositif d'affichage à cristaux liquides.

10. Circuit de protection selon la revendication 1, caractérisé en ce que lesdits dispositifs fusibles (15a-15k) sont disposés en une seule bande à semi-conducteurs (15).

11. Circuit de protection selon la revendication 10, caractérisé en ce que lesdits dispositifs fusibles (15a-15k) sont des dispositifs en silicium amorphe.

12. Circuit de protection selon la revendication 11, caractérisé en ce que ledit dispositif de commutation à semi-conducteurs (16) est un transistor en couches minces en silicium amorphe.

13. Circuit de protection selon la revendication 12, caractérisé en ce que ledit instrument à semi-conducteurs (11) est un dispositif d'affichage à cristaux liquides.

14. Dispositif fusible à semi-conducteurs comprenant :
un substrat isolant (19)
une première couche de Si₃N₄ (20) recouvrant une surface du dit substrat (19);
une deuxième couche de matière semi-conductrice non dopée (21) recouvrant ladite première couche (20);
une troisième couche de matière semi-conductrice dopée (22) recouvrant ladite deuxième couche (21);
une électrode conductrice (23) recouvrant ladite troisième couche (22);
un canal (25), ayant une dimension L, disposé d'un bout à l'autre de ladite électrode conductrice (23) et de ladite troisième couche (22) et disposé en partie dans ladite deuxième couche (21), le fond du dit canal (25) étant situé à la distance d de ladite première couche (20); et
une quatrième couche de Si₃N₄ (24) recouvrant ladite troisième couche (22) et ledit canal (25).

15. Dispositif de protection à semi-conducteurs caractérisé en ce qu'il comprend une pluralité de dispositifs fusibles (15a-15k) selon la revendication 14, disposés sur une seule bande à semi-conducteurs (15).

16. Dispositif de protection à semi-conducteurs selon la revendication 15, caractérisé en ce que ladite dimension L est sélectionnée de manière que lesdits dispositifs fusibles (15a-15k) constituent une protection contre les décharges d'électricité statique au-dessus d'une tension minimum.

17. Circuit de protection caractérisé en ce qu'il comprend une pluralité de dispositifs fusibles à semi-conducteurs (15a-15k) selon la revendication 14 en parallèle avec un transistor en couches minces (16) ayant une grille flottante (18), lesdits dispositifs fusibles (15a-15k) et ledit transistor en couches minces (16) étant en parallèle avec la capacitance d'entrée (14) d'un instrument (11) à protéger par ledit circuit de protection (10).

18. Circuit de protection selon la revendication 17, caractérisé en ce que lesdits dispositifs fusibles (15a-15k) sont disposés en une seule bande à semi-conducteurs (15).

19. Circuit de protection selon la revendication 18, caractérisé en ce que ladite dimension L est sélectionnée de manière que les dispositifs fusibles (15a-15k) constituent une protection contre les décharges d'électricité statique au-dessus d'une tension minimum.

20. Circuit de protection selon la revendication 19, caractérisé en ce que ledit transistor en couches minces (16) constitue une protection contre les décharges d'électricité statique au-dessous de ladite tension minimum.

21. Dispositif fusible à semi-conducteurs selon la revendication 14, caractérisé en ce que ledit matériau semi-conducteur est du silicium amorphe.

22. Circuit de protection selon la revendication 17, caractérisé en ce que ledit matériau semi-conducteur des dispositifs fusibles est du silicium amorphe.

23. Circuit de protection selon la revendication 20, caractérisé en ce que ledit matériau semi-conducteur dudit transistor en couches minces (16) est du silicium amorphe.

## Patentansprüche

1. Schutzschaltung (10) zum Schützen eines Halbleiterinstruments (11) gegen die Entladungen statischer Elektrizität, mit folgenden:
einer Mehrzahl von Halbleiterachmelzvorriahtungen (15a-15k), die parallel zu der Eingangskapazität (14) des besagten Halbleiterinstruments (11) geschaltet sind, wobei die besagten Schmelzvorrichtungen (15a-15k) das besagte Instrument (11) durch Durchbrennen einer dieser Schmelzvorrichtungen, wenn sie einer Entladung statischer Elektrizität oberhalb einer Mindestspannung unterworfen sind, schützen; und
einer Halbleiterachaltvorrichtung (16), die parallel zu den besagten Schmelzvorrichtungen (15a-15k) geschaltet ist, um die durch die Entladungen statischer Elektrizität erzeugten Ströme unterhalb der besagten Mindestspannung abzuleiten.

2. Schutzschaltung nach Anspruch 1, dadurch gekennzeichnet, daß sie auch einen Widerstand (17) in Kombination mit der besagten Eingangskapazität (14) umfaßt, wobei der besagte Widerstand (17) einen solchen Wert aufweist, daß die Widerstands-Kapazitäts-Zeitkonstante des besagten Widerstands (17) und der besagten Eingangskapazität (14) höher als die Schaltzeit der besagten Schmelzvorrichtungen (15a-15k) und geringer als die der besagten Schaltvorrichtung (16) ist.

3. Schutzschaltung nach Anspruch 2, dadurch gekennzeichnet, daß die besagten Schmelzvorrichtungen (15a-15k) Vorrichtungen aus amorphem Silizium sind.

4. Schutzschaltung nach Anspruch 3, dadurch gekennzeichnet, daß die besagte Halbleiterschaltvorrichtung (16) ein Dünnschichttransistor aus amorphem Silizium ist.

5. Schutzschaltung nach Anspruch 4, dadurch gekennzeichnet, daß der besagte Dünnschichttransistor (16) eine potentialfreie Steuerelektrode (18) aufweist.

6. Schutzschaltung nach Anspruch 5, dadurch gekennzeichnet, daß das besagte Halbleiterinstrument (11) eine Flüssigkristallanzeigevorrichtung ist.

7. Schutzschaltung nach Anspruch 3, dadurch gekennzeichnet, daß die besagten Schmelzvorrichtungen (15a-15k) auf einem einzigen Halbleiterband (15) angeordnet sind.

8. Schutzschaltung nach Anspruch 7, dadurch gekennzeichnet, daß die besagte Halbleiterschaltvorrichtung (16) ein Dünnschichttransistor aus amorphem Silizium ist.

9. Schutzschaltung nach Anspruch 8, dadurch gekennzeichnet, daß das besagte Halbleiterinstrument (11) eine Flüssigkristallanzeigevorrichtung ist.

10. Schutzschaltung nach Anspruch 1, dadurch gekennzeichnet, daß die besagten Schmelzvorrichtungen (15a-15k) in einem einzigen Halbleiterband (15) angeordnet sind.

11. Schutzschaltung nach Anspruch 10, dadurch gekennzeichnet, daß die besagten Schmelzvorrichtungen (15a-15k) Vorrichtungen aus amorphem Silizium sind.

12. Schutzschaltung nach Anspruch 11, dadurch gekennzeichnet, daß die besagte Balbleiterachaltvorrichtung (16) ein Dünnschichttransistor aus amorphem Silizium ist.

13. Schutzschaltung nach Anspruch 12, dadurch gekennzeichnet, daß das besagte Halbleiterinstrument (11) eine Flüssigkristallanzeigevorrichtung ist.

14. Halbleiterschmelzvorrichtung mit folgenden:
einem Isoliersubstrat (19),
einer ersten Schicht aus Si₃N₄ (20), die eine Oberfläche des besagten Substrats (19) abdeckt;
einer zweiten Schicht aus nichtdotiertem Halbleitermaterial (21), die die besagte erste Schicht (20) abdeckt;
einer dritten Schicht aus dotiertem Halbleitermaterial (22), die die besagte zweite Schicht (21) abdeckt;
einer die besagte dritte Schicht (22) abdeckenden leitenden Elektrode (23);
einem Kanal (25) mit einer Abmessung L, der von einem Ende zum anderen der besagten leitenden Elektrode (23) und der besagten dritten Schicht (22) angeordnet ist und teilweise in der besagten zweiten Schicht (21) angeordnet ist, wobei der Boden des besagten Kanals (25) sich im Abstand d von der besagten ersten Schicht (20) befindet; und
einer vierten Schicht aus Si₃N₄ (24), die die besagte dritte Schicht (22) und den besagten Kanal (25) abdeckt.

15. Halbleiterschutzvorrichtung, da-durch gekennzeichnet, daß sie eine Mehrzahl von Schmelzvorrichtungen (15a-15k) nach Anspruch 14, die auf einem einzigen Halbleiterband (15) angeordnet sind, umfaßt.

16. Halbleiterachutzvorrichtung nach Anspruch 15, dadurch gekennzeichnet, daß die besagte Abmessung L so ausgewählt ist, daß die besagten Schmelzvorrichtungen (15a-15k) einen Schutz gegen die Entladungen statischer Elektrizität oberhalb einer Mindestspannung darstellen.

17. Schutzschaltung, dadurch gekennzeichnet, daß sie eine Mehrzahl von Halbleiterschmelzvorrichtungen (15a-15k) nach Anspruch 14 parallel zu einem Dünnschichttransistor (16) mit einer potentialfreien Steuerelektrode (18) umfaßt, wobei die besagten Schmelzvorrichtungen (15a-15k) und der besagte Dünnschichttransistor (16) parallel zu der Eingangskapazität (14) eines durch die besagte Schutzschaltung (10) zu schützenden Instruments (11) geschaltet sind.

18. Schutzschaltung nach Anspruch 17, dadurch gekennzeichnet, daß die besagten Schmelzvorrichtungen (15a-15k) in einem einzigen Halbleiterband (15) angeordnet sind.

19. Schutzschaltung nach Anspruch 18, dadurch gekennzeichnet, daß die besagte Abmessung L so ausgewählt ist, daß die Schmelzvorrichtungen (15a-15k) einen Schutz gegen die Entladungen statischer Elektrizität oberhalb einer Mindestspannung bilden.

20. Schutzschaltung nach Anspruch 19, dadurch gekennzeichnet, daß der besagte Dünnschichttransistor (16) einen Schutz gegen die Entladungen statischer Elektrizität unterhalb der besagten Mindestspannung bildet.

21. Halbleiterschmelzvorrichtung nach Anspruch 14, dadurch gekennzeichnet, daß das besagte Halbleitermaterial aus amorphem Silizium ist.

22. Schutzschaltung nach Anspruch 17, dadurch gekennzeichnet, daß das besagte Halbleitermaterial der Schmelzvorrichtungen aus amorphem Silizium ist.

23. Schutzschaltung nach Anspruch 20, dadurch gekennzeichnet, daß das besagte Halbleitermaterial des besagten Dünnschichttransistors (16) aus amorphem Silizium ist.

## Claims

1. Protection circuit (10) for protecting a semiconductor device (11) from discharges of static electricity comprising:
- a plurality of semiconductor fuse units (15a-15k) mounted in parallel with the input capacitor (14) of the said semiconductor device (11), the said fuse units (15a-15k) protecting the said device (11) by one of these fuse units blowing when they are subjected to a discharge of static electricity above a minimum voltage; and
- a semiconductor switching unit (16) mounted in parallel with the said fuse units (15a-15k) in order to shunt the currents produced by the discharges of static electricity below the said minimum voltage.

2. Protection circuit according to Claim 1, characterized in that it also comprises a resistor (17) in combination with the said input capacitor (14), the said resistor (17) having a value such that the resistance/capacitance time constant of the said resistor (17) and of the said input capacitor (14) is larger than the switching time of the said fuse units (15a-15k) and less than that of the said switching unit (16).

3. Protection circuit according to Claim 2, characterized in that the said fuse units (15a-15k) are units made of amorphous silicon.

4. Protection circuit according to Claim 3, characterized in that the semiconductor switching unit (16) is an amorphous silicon thin-film transistor (5).

5. Protection circuit according to Claim 4, characterized in that the said thin-film transistor (16) possesses a floating gate (18).

6. Protection circuit according to Claim 5, characterized in that the said semiconductor device (11) is a liquid-crystal display unit.

7. Protection circuit according to Claim 3, characterized in that the said fuse units (15a-15k) are arranged on a single semiconductor strip (15).

8. Protection circuit according to Claim 7, characterized in that the said semiconductor switching unit (16) is an amorphous silicon thin-film transistor.

9. Protection circuit according to Claim 8, characterized in that the said semiconductor device (11) is a liquid-crystal display unit.

10. Protection circuit according to Claim 1, characterized in that the said fuse units (15a-15k) are arranged as a single semiconductor strip (15).

11. Protection circuit according to Claim 10, characterized in that the said fuse units (15a-15k) are units made of amorphous silicon.

12. Protection circuit according to Claim 11, characterized in that the semiconductor switching unit (16) is an amorphous silicon thin-film transistor.

13. Protection circuit according to Claim 12, characterized in that the said semiconductor device (11) is a liquid-crystal display unit.

14. Semiconductor fuse unit comprising:
an insulating substrate (19)
a first film of Si₃N₄ (20) covering a surface of the said substrate (19);
a second film of undoped semiconductor material (21) covering the said first film (20);
a third film of doped semiconductor material (22) covering the said second film (21);
a conducting electrode (23) covering the said third film (22);
a channel (25), having a dimension L, arranged from one end to the other of the said conducting electrode (23) and of the said third film (22) and arranged in part in the said second film (21), the bottom of the said channel (25) being situated at the distance d from the said first film (20); and
a fourth film of Si₃N₄ (24) covering the said third film (22) and the said channel (25).

15. Semiconductor protection unit characterized in that it comprises a plurality of fuse units (15a-15k) according to Claim 14, which are arranged on a single semiconductor strip (15).

16. Semiconductor protection unit according to Claim 15, characterized in that the said dimension (L) is selected in such a way that said fuse units (15a-15k) constitute a protection against discharges of static electricity above a minimum voltage.

17. Protection circuit characterized in that it comprises a plurality of semiconductor fuse units (15a-15k) according to Claim 14 in parallel with a thin-film transistor (16) having a floating gate (18), the said fuse units (15a-15k) and the said thin-film transistor (16) being in parallel with the input capacitor (14) of a device (11) to be protected by the said protection circuit (10).

18. Protection circuit according to Claim 17, characterized in that the said fuse units (15a-15k) are arranged as a single semiconductor strip (15).

19. Protection circuit according to Claim 18, characterized in that the said dimension (L) is selected in such a way that said fuse units (15a-15k) constitute a protection against discharges of static electricity above a minimum voltage.

20. Protection circuit according to Claim 19, characterized in that the said thin-film transistor (16) constitutes a protection against discharges of static electricity below the said minimum voltage.

21. Semiconductor fuse unit according to Claim 14, characterized in that the said semiconductor material is amorphous silicon.

22. Protection circuit according to Claim 17, characterized in that the said semiconductor material of the fuse units is amorphous silicon.

23. Protection circuit according to Claim 20, characterized in that the said semiconductor material of the said thin-film transistor (16) is amorphous silicon.
